# EUROPEAN PATENT SPECIFICATION

(11) **EP 2 249 389 B1**
(45) Date of publication and mention of the grant of the patent: **20.02.2019**
(21) Application number: 10174657.6
(22) Date of filing: 25.02.2004
(51) Int. Cl.: H01L 27/146

(54) **Method of manufacturing a photodetecting device**
Herstellungsverfahren einer Lichterkennungsvorrichtung
Méthode de fabrication d'un dispositif de photodétection

(43) Date of publication of application: 10.11.2010
(62) Divisional of application: 04714396.1
(73) Proprietor: Sony Semiconductor Solutions Corporation, Atsugi-shi Kanagawa (JP)
(72) Inventor: Dupont, Frédéric, 38180, SEYSSINS (FR); Cayrefourcq, Ian, 38330, SAINT NAZAIRE LES EYMES (FR)
(74) Representative: MFG Patentanwälte Meyer-Wildhagen Meggle-Freund Gerhard PartG mbB

(56) References cited:
- EP-A2- 1 256 984
- WO-A1-2005/086236
- DE-C1- 19 838 442
- US-A1- 2001 026 001
- US-A1- 2004 005 729

## Description

### Field of the invention

The invention relates to a method of manufacturing of a photodetecting device, comprising a photosensitive part and an electronic circuit part, such as a CMOS image sensor.

Such a photodetecting device comprises a plurality of photodetecting units, also called pixels, which are usually arranged in rows and columns. Each of the photodetecting units comprises:
- a photosensitive part, like a photodiode, at its surface, able to convert the received photons to an electronic signal;
- at least one electronic part, like a transistor, electrically connected to the photosensitive part, able to process, once having received a command "ON", the accumulated electronic charges coming from the latter to other components (amplificatory, switch, ...) to readout means (for more details, see for instance §2 and §3 of EP 1,256,984 document).

One of the main advantages of this technology is the rapid readout of the light information, due to a light acquisition in parallel over the different units.

### Background of the invention

Several kinds of structural configuration of photodetecting devices have been proposed.

As disclosed for example in US 6,380,5668 document, a first known photodetecting device has a horizontal configuration, i.e. each photosensitive unit (or pixel) comprises on its surface, side by side, a photosensitive element and an electronic element, separated by a field isolation layer.

From documents DE 198 38 442, US20004/0005729 and US2001/0026001 methods of manufacturing a photodetecting device are known.

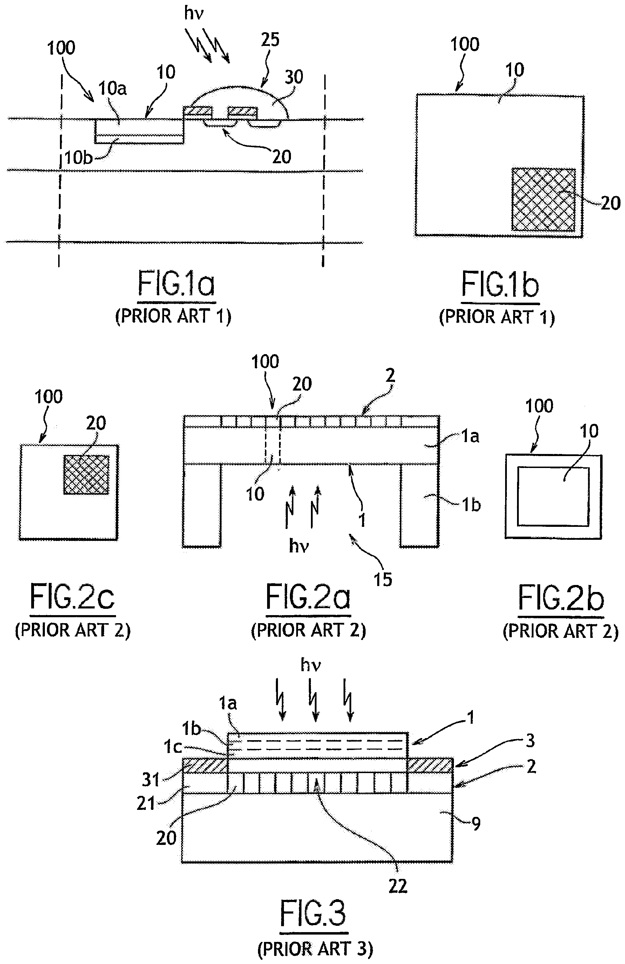

Figure 1a illustrates such a pixel 100, having a photodiode 10 (composed here, for example, of a p-type layer 10a and a n-type layer 10b), able to convert the received photons (hν) in electronic charges and, beside, a transistor 20 (surrounded by a field isolation layer 30) able to receive the electronic charges from the photodiode 10a.

As shown on figure 1b, which represents a front view of the photoreceivor pixel surface 100, the latter comprises a photosensitive part 10 and a non-photosensitive part 25.

Typically, the photosensitive surface represents 30% to 60% of the entire pixel surface.

Consequently, the photosensing is not optimised, since a part of the photons arriving on the pixel are lost.

A solution would be to reduce the size of the electronic part 20.

But such miniaturization has its own technical limits. Furthermore, even if the electronic part is drastically reduced in size, the surface of the pixel 100, in such a horizontal configuration, will not be dedicated to photosensing by 100%.

It was proposed to add a lens over each pixel for focusing the entire light, arriving on the pixel, to the photosensitive element; as disclosed in the US 6,040,591 document.

But this solution is not desirable, due to its high cost and to an efficiency not sufficient enough.

A second kind of known photosensitive device is the so-called "back-illuminated" device.

Figure 2a illustrates this device which initially comprises a doped substrate (for instance a p⁺-type) covered by a top layer 1a having another type of doping (for instance a p⁻-type), and an electronic circuit layer 2 (including a plurality of transistors 20). The substrate is then selectively back-etched, such as to preserve the periphery 1b, and thus forming a central opening 15. The periphery 1a of the substrate then holds a thin structure comprising the top layer 1a and the circuit layer 2.

This structure allows the thin top layer 1a to receive the photons coming from the "back" (i.e. passing through the opening 15) and delivering an electronic signal associated with this photon illumination to the transistors 20 included in the overlying circuit layer 2.

From Figures 2b and 2c, which represent respectively front views of the surface of a pixel 100 and of the opposite surface, it appears that this device doesn't have the drawbacks of the said first photodetecting device, as the transistor 20 is not on the photoreceiving surface, the latter being then close to 100 % dedicated to photosensing.

However, the manufacturing of this second photodetecting device is high cost and implies to lose an important part of the back substrate during the etch-back process.

A third known photodetecting device has a vertical configuration, i.e. electronic part is buried under the photosensitive part, as disclosed for instance in EP 1,256,984 ; EP 1,026,747; EP 964,570 ; US 5,084,747.

Figure 3 illustrates such photodetecting device which is fabricated from a substrate 9 from which an electronic circuit layer 2 is formed (by crystal growth, doping, plating, deposition,...). This circuit layer 2 usually comprises a circuit central part 22 including the transistors 20 of each pixel and a peripheral part 21 comprising electronic components dedicated to addressing (i.e. collecting the signals from the pixels and sending them to readout means). The circuit layer 2 is covered by an isolation layer 3, mainly of a dielectric material with a shielding 31 on the periphery for protecting the peripheral part 21 from illumination. The isolation layer 3 comprises electrical conductor channels (not shown), so called "via hole", so as to electrically link the photosensitive part to the electronic part. A doped photosensitive layer 1 (for instance a PiN structure composed of a p-type layer 1a, an intrinsic layer 1b and a n-type layer 1c) is formed on the isolation layer 3.

Due to the non-crystallinity of the isolation layer 3, a crystal growth of the photosensitive layer 1 is not possible. So, the photosensitive layer 1 is formed by deposition, and has an amorphous structure.

Now, an amorphous layer comprises many charges traps able to immobilise electrons and holes during a time, so called "time of relaxation". These trapped charges slow down the reception and interfere with the next detections.

The average number of electrons generated by incoming photons is then lower for non crystalline layers, from which it follows a lower efficiency for this type of device and leads to a less sensible detector.

### Summary of the invention

The invention tends, in a first aspect, to improve the previous manufacturing methods of photodetecting devices by proposing a method of manufacturing photodetecting device in accordance with claim 1.

Other characteristics of the invention are the following ones:
- step (b) comprises a molecular adhesion;
- step (b) comprises, after the molecular adhesion, a thermal treatment, the material which constitutes the field isolation zone being chosen for improving the bonding when this thermal treatment is processed;
- the material chosen for the field isolation zone is a dielectric, such as SiO₂, Si₃N₄ or SiₓO_{y}N_{z};
- the step of removing the substrate is operated by at least one of the following techniques : chemical etching, selective chemical etching, grinding , polishing, CMP;
- the step of removing the substrate comprises an energy input for detaching the said substrate over an embrittlement zone previously formed in the said substrate;
- the method further comprises a formation of the said embrittlement zone in the said substrate by implantation of atomic species, such as hydrogen and/or helium;
- the method further comprises a formation of the said embrittlement zone by the following steps :
   ✔ providing a third and a fourth wafers;
   ✔ etching a surface of at least one of the third and the fourth wafers, in order to increase the surface roughness;
   ✔ bonding the third and the fourth wafers at the rough surface(s), forming thus the said substrate, the rough interface being the said embrittlement zone;
- the method further comprises a surface finishing step of the detached surface, employing at least one of the following techniques : selective chemical etching, polishing, CMP, oxidation, thermal anneals;
- the formation of the photosensitive layer on the first substrate comprises crystal growth and doping;
- the method further comprises, before step, a formation of the isolation layer on the photosensitive layer or on the circuit layer;
- the formation of the field isolation layer comprises the formation of a shielding to photons in periphery of the field isolation layer over a determinate width;
- the circuit layer comprises a plurality of transistors, and in that the circuit layer is patterned such that, once step (c) is implemented, parts of the photosensitive layer are electrically connected to some transistors by some conductive via, forming thus a plurality of photodetecting units (so-called pixels);
- the electronic components by pixel comprise CMOS component.

### Brief description of the drawings

Other characteristics, purposes and advantages of the invention will appear in the next detailed description of the invention, illustrated by the following drawings :
Figure 1a is a schematic cross-sectional view of a photodetecting device according to a first prior art.
Figure 1b is a schematic front view of the surface, of the photodetecting device according to the first prior art, which detects photons.
Figure 2a is a schematic cross-sectional view of a photodetecting device according to a second prior art.
Figure 2b and 2c are respectively schematic front views of the surface of the photodectecting device according to the second prior art, which detects the photons and the opposite surface.
Figure 3 is a schematic cross-sectional view of a photodetecting device according to a third prior art.
Figure 4 is a schematic cross-sectional view of a first detecting device not claimed but useful to understand the invention.
Figure 5 is a schematic cross-sectional view of a second photodetecting device manufactured by the method of the invention.
Figure 6a to 6m are the different steps of a first method of manufacturing the first photodetecting device not claimed but useful to understand the invention.
Figure 7a to 7h are different steps of a second method of manufacturing a photodetecting device according to the invention.

### Detailed description of the invention.

A first object of the invention is the manufacturing of a photodetecting device having vertical configuration, comprising a photosensitive layer made of a crystalline semiconductor material.

A second object of the invention is to process a method of manufacturing such photodetecting device so that the photosensing surface is 100% dedicated or closed to 100% dedicated to the photosensing.

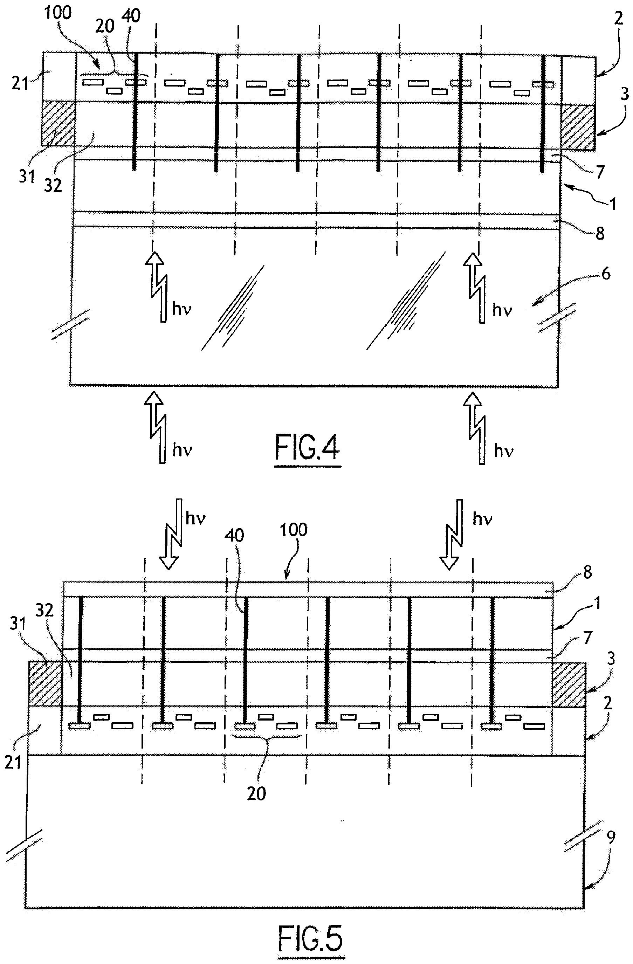

Figure 4 and Figure 5 respectively show a first and a second photodetecting device, the latter being manufactured according to the invention, comprising:
- a photosensitive layer 1 ;
- an electronic circuit layer 2 ;
- a field isolation layer 3 separating the photosensitive layer 1 and the circuit layer 2.

Preferably, the photosensitive layer 1 is made of monocrystalline semiconductor material, like Si, SiₓGe₁₋ₓ or some III-V or II-VI alloys.

As the photosensitive layer 1 acts as a photodiode, it has at least one electrical junction, and thus comprises doping elements whose nature and/or concentration suddenly changes in the thickness of the photosensitive layer 1.

The photosensitive layer 1 can then be a PN-type junction, a PP⁺-type junction, a NN⁻-type junction, a PiN-type junction, or other type of junctions.

In order to facilitate or allow conversion of the received photons to electronic charges, the photosensitive layer 1 is preferably covered and underlied by electrode layers respectively 8 and 7, for biasing it.

One electrode layer 8, located on the photoreceiving side of the photosensitive layer 1, has to be transparent to permit at least part of the photons to cross it, and thus to permit the underlying photosensitive layer 1 to receive them.

This electrode layer 8 can be for instance made of ITO (Indium Tin Oxide).

The other electrode layer 7 can be of any electrical conductive material, such as aluminium or TiW.

The circuit layer 2 includes the whole electronic components that receive, and optionally amplify, switch and command electronical charges coming from the photosensitive layer 1.

This circuit layer 2 has preferably two areas:
- a central zone 22 which includes electronic components of the pixels 100,
- a peripheral zone 21 which includes the electronic components dedicated to the addressing process of the different pixels electronic components located in the central zone 22.

Each photodetecting unit 100 (or pixels 100) comprises at least one electronic component 20 (illustrated in figures 4 and 5 as a transistor) and the part of the photosensitive layer 1 which is directly above the said at least electronic component 20.

In a pixel 100, the part of photosensitive layer 1 and the at least electronic component 20 are electronically linked by a via hole 40, a via hole 40 being an electrically conductive channel.

The via hole 40 can be for instance filled with Al or TiW, or other conductive materials.

This via hole 40 allows to link the photosensitive layer 1 to the input of the at least electronic component 20 (illustrated in the figures 4 and 5 as the source of a transistor 20).

A field isolation layer 3 separates the photosensitive layer 1 from the circuit layer 2, and comprises, at its peripheral part 31 a shielding whose function is the protection of the peripheral zone 21 of the circuit layer 2 (and the included addressing components) from the outside illumination. Material chosen for shielding may be all non transparent material at the considered wavelength, for instance tungsten or nickel.

The central zone 32 of the isolation layer 3 electrically separates the circuit layer 2 from the photosensitive layer 1, except for the via holes 40 which passes through.

The central zone 32 can be of a dielectric material, such as SiO₂, Si₃N₄, SiₓO_{y}N_{z}.

Further to the three preceding layers (i.e. photosensitive layer 1, circuit layer 2 and isolation layer 3), the photodetecting device preferably comprises a holding substrate which mechanically stiffens the whole device.

Figure 4 shows a first photodetecting device wherein the holding substrate 6 is located on the side of the photosensitive layer 1.

For allowing the photons to reach the photosensitive layer 1, this holding substrate 6 has to be made of a transparent material to photons, as glass or quartz or any other material transparent to the wavelength of interest.

This first photodetecting device is then illuminated "by the back".

Furthermore, it allows electrical contacts directly to the electronic components 20 of the uncovered circuit layer 2.

Figure 5 shows a second photodetecting device manufactured according to the invention wherein the holding substrate 9 is located on the side of the circuit layer 2.

The holding substrates 9 can be in any material, like a semiconductor material, as Si.

This second photodetecting device is then illuminated "by the front".

Photodetecting device of the present invention does not necessary comprise a photosensitive layer 1 in an amorphous semiconductor material, but can comprise a photosensitive layer 1 of crystalline semiconductor material, even if the underlied layer (electrode layer 7 or 8 and/or isolation layer 3) is not of a crystalline material, contrary to the photodetecting device of the prior art wherein the photosensitive layer 1 has to be in an amorphous material because of the non possibility of growing a crystalline material from a non crystalline surface.

The photodetecting device according to the invention then improves the reliability and the efficiency of the photosensitive layer 1, as crystalline semiconductor material does not comprise any charge-traps like in an amorphous material, and consequently does not present problems of a low average number of electrons generated by incoming photons like in amorphous and then it leads to a more sensible detector.

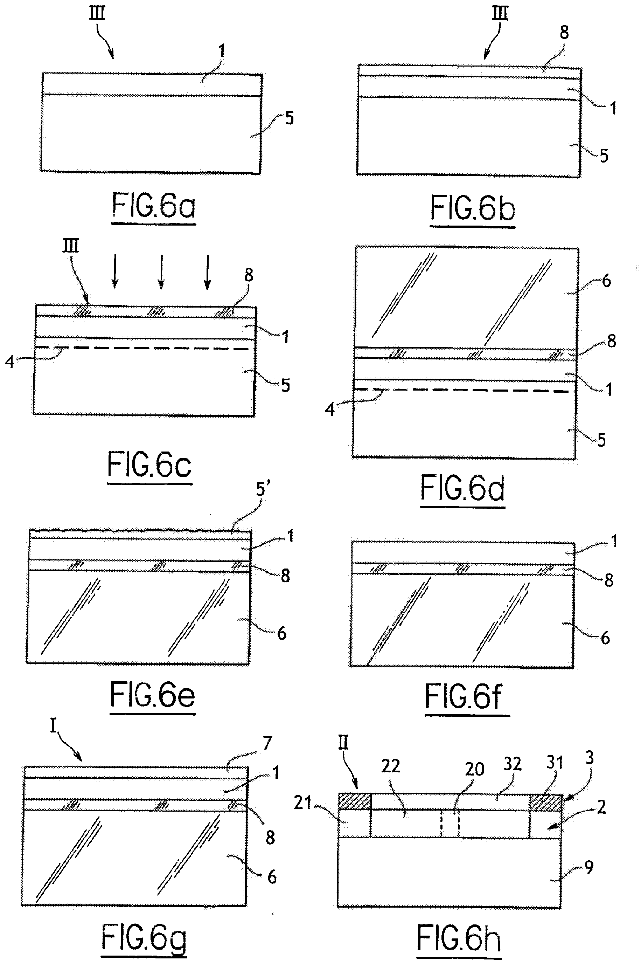

Figure 6a to 6m show several steps of a first method of manufacturing a photodetecting device (the said first photodetecting device referring to figure 4).

Referring to figure 6a, a first step comprises providing a semiconductor substrate 5 on which the photosensitive layer 1 is grown, in order to make a donor substrate III.

The first substrate 5 is preferably a monocristalline substrate which can be made of a bulk material (like Si or AsGa) or made of different sorts of materials like a first substrate 5 comprising a bulk substrate Si and a buffer structure (which confines plastic defaults and adapts the lattice parameter) in SiGe.

In any case, the first substrate 5 presents a top surface preferably monocrystalline with little plastic defaults.

The photosensitive layer 1 is then grown by any known epitaxial techniques, such as CVD techniques, as PECVD, MOCVD, LEPCVD...

In a variant, the photosensitive layer 1 is formed by deposition in order to make a non crystalline photosensitive layer 1 like an amorphous structures.

In order to create the electrical junction in the photosensitive layer 1, steps of doping succeeds to the growth step, such that the photosensitive layer 1 comprises at least two levels of doped zones, a doped zone having a doping element with different concentration and/or different nature from the other doped zones.

Thus, the photosensitive layer 1 can present a PN junction, a NN-junction, a PP+ junction, a PiN junction...., depending on the requirement.

Referring to figure 6b, a first electrode layer 8 is optionally formed on the photosensitive layer 1. This electrode layer 8 is made of a transparent conductive layer, such as ITO.

Referring to figure 6c, an implanting step consists in implanting atomic species like hydrogen and/or helium ions, through the top surface of the donor substrate III, so as to create in the first substrate 5 an embrittlement zone 4.

The concentration and the energy of the atomic species are chosen such that the embrittlement zone 4 is located in the first substrate 5 and presents some mechanical weakness comparing with the other part of the donor substrate III.

Referring to figure 6d, a holding substrate 6 is provided and bonded to the donor substrate III.

This holding substrate 6 is made of a material transparent to photons that the photodetecting device will receive, such as glass or quartz.

Before bonding, the donor substrate III and/or the holding substrate 6 can be polished or cleaning in order to reduce the rugosity.

The bonding can be realized by molecular adhesion, which is mainly due to hydrophily of the surfaces to be bonded.

Preparation of the surface(s) to be bonded can be optionally done for improving the bonding energy between the holding substrate 6 and the donor substrate III, such as for example an exposition to a plasma (of oxygen for example), a cleaning, a brushing, ...

For further details of the technique of bonding that can be used, the book "semiconductor wafer bonding science and technology" of Q-Y Tung and U. Gösele (a Wiley Interscience publication, Johnson Wiley and Sons, Inc.) can be read.

The bonding interface can be optionally strengthened by a thermal treatment, at a low bonding temperature for instance 600°C-900°C for 1 hour. In addition, bonding could be assisted by a plasma activation.

Referring to figure 6e, the first substrate 5 is reduced by bringing some energy at the embrittlement zone 4 in order to create a detachment of the major part of the first substrate 5.

The energy provided can be for instance mechanical energy and/or thermal energy or other kind of energy.

A first alternative of reduction of the first substrate 5 can also be processed, in which the formation of the embrittlement zone 4 is differently done than by implanting atomic species (as illustrated in figure 6c), but by implementing, before the formation of the photosensitive layer 1 (referring to figure 6a), the following steps :
- providing two wafers,
- etching a surface of at least one of the two wafers, in order to increase the surface roughness,
- bonding the two wafers;
forming thus the said first substrate 5, the rough interface being the said embrittlement zone 4.

The fabrication of such a first substrate 5, also called "dismountable substrate", by controlling of the bonding energy, is described for example in the FR 2,823,599 document, the principle being based on a reduction of the bonding forces between the said two wafers bonded together, relative to an optimal bonding.

Then the detaching of the major part of the first subtrate 5 is substantially processed as above-described referring to figure 6d.

A second alternative of reduction of the first substrate 5 is the etch-back technique (i.e. a chemical etching from the back of the first substrate 5).

Whatever techniques of reduction of the first substrate 5 used, after having reduced the first substrate 5, a remaining part 5' of the first substrate 5 stays (referring to figure 6e) and is removed by mainly finition means as polishing, selective etching, CMP, oxidation... in order to obtain a structure composed of the holding structure 6, the optional transparent first electrode layer 8, and the photosensitive layer 1, as shown in figure 6f.

Referring to figure 6g, an optional second electrode layer 7 is formed on the photosensitive layer 1, this second electrode layer 7 being made of an electrically conductive material, such as Al, TiW.

The technique for forming this second electrode 7 can be an electroplating.

Referring to figure 6h, a second wafer II is formed by providing a second substrate 9, on which a circuit layer 2 is formed.

The second substrate 9 is preferably made of a monocrystalline material such as bulk material like Si, or a composite substrate comprising for instance a buffer structure.

On the second substrate 9, is formed an electronic circuit layer 2, such that a central part 22 includes the whole electronic components of the different pixels 100, and a peripheral part 21 including the electronic components dedicated to the addressing.

Techniques employed for manufacturing those components are conventional ones, as for instance epitaxy, doping, depositing, electro plating...

The layout of the circuit layer 2 is chosen to process the electronic charges coming from the photosensitive layer 1 (which will next overly the circuit layer 2), choosing thus in consequence a circuit configuration and a path for the metallic tracks, inside the circuit layer 2.

For example, a CMOS circuit can be manufactured in each pixel 100.

A field isolation layer 3 is then formed on the circuit layer 2, this isolation layer 3 comprising a peripheral part 31 of shielding for protecting the underlied peripheral part 21 of the circuit layer 2, and a central part 32 which covers the central part 21 of the circuit layer 2.

The shielding material chosen for the peripheral part 31 of the isolation layer 3 may be all non transparent material at the considered wavelength, for instance tungsten or nickel.

The material chosen for the central part 32 of the isolation layer 3 is preferably made of a dielectric material, such as SiO₂, Si₃N₄, SiₓO_{y}N_{z},...

This isolation layer 3 will then electrically separate the circuit layer 2 from the photosensitive layer 1 (which will next underly the isolation layer 3).

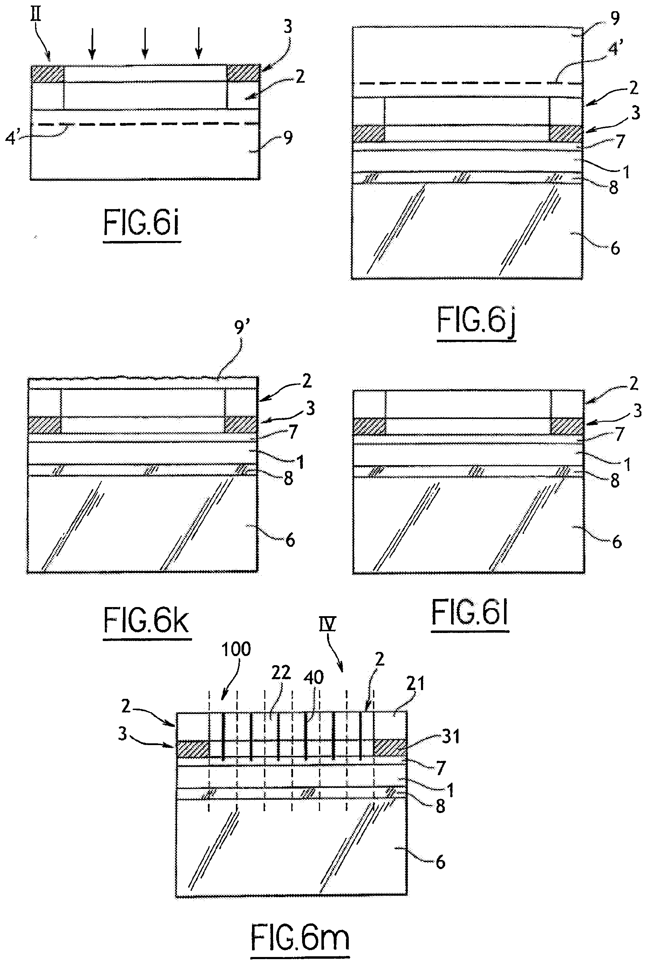

Referring to figure 6i, implanting step is processed inside the second substrate 9 (like the implanting step in the substrate 5 described above, referring to figure 6c) in order to create a second embrittlement zone 4' in the second substrate 9.

Referring to figure 6j, the second wafer II and the first wafer I are then bonded.

The technique of bonding used for this step is similar to the technique of bonding used during step referring to figure 6d (and described above).

Some energy is provided in order to detach a major part of the second substrate 9, this energy can be mechanical energy, and/or thermal energy, or other kind of energy.

The above-mentioned two other alternatives for the reduction of the first substrate 5, can also be adapted to the reduction of the second substrate 9.

Referring to figure 6k and 6l, after having reduced the second substrate 9, the remaining part 9' of it is then removed by some technique of surface finition, such as polishing, selective etching, CMP, oxidation, thermal anneals.

Referring to figure 6m, the photodetecting device is finally obtained by forming via holes from the surface of the circuit layer 2 to the photosensitive layer 1 (by technique of masks and etching through the non-masked surface of the circuit layer 2) and by filling them with an electrical conductive layer, such as Al, TiW, or another material, in order to create conductive vias 40 between the input of some electronic components included in the central part 22 of the circuit layer 2, and the photosensitive layer 1, forming thus the said first photodetecting device (referring to figure 4).

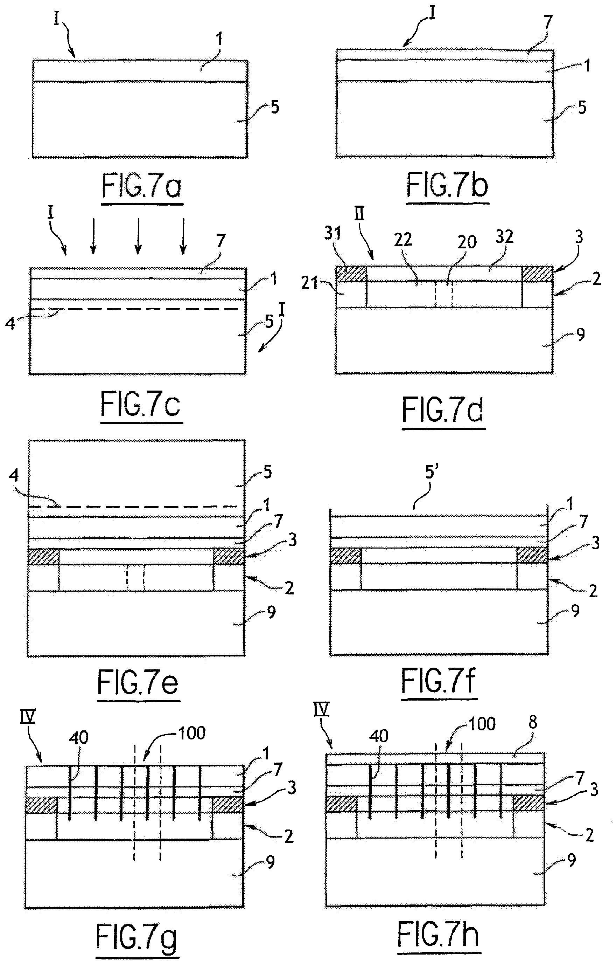

Referring to figure 7a to 7h, a second method of manufacturing a photodetecting device (for obtaining the said second photodetecting device referring to figure 5), is proposed according to the invention.

After having formed the photosensitive layer 1 and a first substrate 5 (referring to figure 7a) in order to form a first wafer I, a first electrode layer 7 is formed on the photosensitive layer 1 (referring to figure 7b).

This first electrode layer 7 being non-transparent to photons (contrary to the first electrode layer 8 referring to figure 6b of the said first method of manufacturing according to the invention).

After having implanting atomic species in the first wafer I and having formed a second wafer II including a holding substrate 9, a circuit layer 2 and a field isolation layer 3 (with techniques substantially and respectively similar to those above-described referring to figure 6c and figure 6h).

Then, referring to figure 7e, the first wafer I is directly bonded to the second wafer II for obtaining a structure comprising successively a circuit layer 2, a field isolation layer 3, an optional first electrode layer 7 and a photosensitive layer 1.

It is noticed that, contrary to the said first method of manufacturing a photodetecting device, this second method does not comprise steps of providing and bonding a transparent holding substrate 6 previously to the bonding between the first and second wafers I-II (referring to figure 6d).

After having reduced the first substrate 5 (with the same technique as above described referring to figure 6c and figure 6d or, with one of the said alternative techniques as above-described for the said first method of manufacturing a photodetecting device), and having removed the remaining part 5' of the first substrate 5, via holes 40 are formed from the surface of the photosensitive layer 1 to inputs of some electronic components of the central part 22 of the photosensitive layer 2, passing through the optional first electrode layer 7 and the isolation layer 3 (with techniques similar to those used referring to figure 6m).

Referring to figure 7h, an optional second electrode layer 8 is formed on the photosensitive layer 1, with a transparent conductive material such as ITO, so that at least a part of the photons to be received can cross it.

The said second detecting device (referring to figure 5) is then formed.

## Claims

1. Method of manufacturing a photodetecting device comprising the following steps:
(a) providing a first wafer (I), comprising the following steps:
- forming a photosensitive layer (1) made of a material chosen from crystalline semiconductor materials, on a first substrate (5);
- forming a first electrode layer (7) made of an electrically conductive material on the photosensitive layer (1);
(b) providing a second wafer (II), comprising the following steps:
- forming a circuit layer (2) including electronic components on a holding substrate (9),
- forming a field isolation layer (3) covering the circuit layer (2);
(c) bonding the first wafer (I) and the second wafer (II) so as to form a structure comprising successively the holding substrate (9), the circuit layer (2), the field isolation layer (3), the first electrode layer (7), the photosensitive layer (1), and the first substrate (5);
(d) removing the first substrate (5);
(e) forming electrically conductive via (40) so as to electrically connect the photosensitive layer (1) to inputs of some electronic components of the circuit layer (2);
(f) forming a second electrode layer (8) made of a transparent electrical conductive material, such as ITO, on the photosensitive layer (1).

2. Method of manufacturing a photodetecting device according to claim 1, **characterized in that** step (c) comprises a molecular adhesion.

3. Method of manufacturing a photodetecting device according to claim 2, **characterized in that** step (c) comprises, after the molecular adhesion, a thermal treatment, at least one of the materials which constitutes the field isolation layer (3) being chosen for improving the bonding when this thermal treatment is processed.

4. Method of manufacturing a photodetecting device according to one of claims 1 to 3, **characterized in that** the material chosen for the field isolation layer (3) is a dielectric, such as SiO₂, Si₃N₄ or SiₓO_{y}N_{z}.

5. Method of manufacturing a photodetecting device according to one of claims 1 to 4, **characterized in that** the step of removing the first substrate (5) is realized by at least one of the following techniques: chemical etching, selective chemical etching, grinding, polishing, CMP.

6. Method of manufacturing a photodetecting device according to one of claims 1 to 5, **characterized in that** it comprises a step of forming an embrittlement zone (4) in the first substrate (5) by implantation of atomic species, such as hydrogen and/or helium and **in that** the step of removing the first substrate (5) comprises an energy input for detaching said substrate (5) over an embrittlement zone (4).

7. Method of manufacturing a photodetecting device according to one of claims 1 to 5, **characterized in that** it further comprises forming an embrittlement zone (4) in the first substrate (5) by following steps:
- providing a third and a fourth wafers;
- etching a surface of at least one of the third and the fourth wafers, in order to increase the surface roughness;
- bonding the third and the fourth wafers at the rough surface(s), thereby forming said first substrate (5), the rough interface being said embrittlement zone (4) and **in that** the step of removing the first substrate (5) comprises an energy input for detaching said substrate (5) over said embrittlement zone (4)

8. Method of manufacturing a photodetecting device according to one of claims 6 to 7, **characterized in that** step (d) further comprises removing the remaining part (5') of the first substrate (5), employing at least one of the following techniques: selective chemical etching, polishing, CMP, oxidation, thermal anneals.

9. Method of manufacturing a photodetecting device according to one of claims 1 to 8, **characterized in that** the formation of the photosensitive layer (1) on the first substrate (5) comprises crystal growth and doping.

10. Method of manufacturing a photodetecting device according to one of claims 1 to 9, **characterized in that** the via holes are formed during step (e) through the surface of the circuit layer (2), from inputs of some electronic components of the circuit layer (2) to the photosensitive layer (1).

11. Method of manufacturing a photodetecting device according to one of claims 1 to 10, **characterized in that** the formation of the field isolation layer (3) according to step (b) comprises the formation of a shielding to photons in the periphery of the field isolation layer (3) over a determinate width.

12. Method of manufacturing a photodetecting device according to one of claims 1 to 11, **characterized in that** the circuit layer (2) comprises a plurality of transistors (20), and **in that** the circuit layer (2) is patterned such that, once step (e) is implemented, parts of the photosensitive layer (1) are electrically connected to some transistors by some conductive vias, forming thus a plurality of photodetecting units (100).

13. Method of manufacturing a photodetecting device according to claim 12, **characterized in that** the electronic components (20) in the photodetecting units (100) comprise CMOS components.

## Patentansprüche

1. Verfahren zum Herstellen einer Fotodetektionsvorrichtung, das die folgenden Schritte umfasst:
(a) Bereitstellen eines ersten Wafers (I), was die folgenden Schritte umfasst:
- Bilden einer fotoempfindlichen Schicht (1), die aus einem Material gebildet ist, das aus kristallinen Halbleitermaterialien ausgewählt ist, auf einem ersten Substrat (5);
- Bilden einer ersten Elektrodenschicht (7), die aus einem elektrisch leitfähigen Material gebildet ist, auf der fotoempfindlichen Schicht (1);
(b) Bereitstellen eines zweiten Wafers (II), was die folgenden Schritte umfasst:
- Bilden einer Schaltkreisschicht (2), die elektronische Komponenten beinhaltet, auf einem Haltesubstrat (9),
- Bilden einer Feldisolationsschicht (3), die die Schaltkreisschicht (2) bedeckt;
(c) Bonden des ersten Wafers (I) und des zweiten Wafers (II), sodass eine Struktur gebildet wird, die sukzessive das zweite Substrat (9), die Schaltkreisschicht (2), die Feldisolationsschicht (3), die erste Elektrodenschicht (7), die fotoempfindliche Schicht (1) und das erste Substrat (5) umfasst;
(d) Entfernen des ersten Substrats (5);
(e) Bilden eines elektrisch leitfähigen Vias (40), sodass die fotoempfindliche Schicht (1) mit Eingängen mancher elektronischer Komponenten der Schaltkreisschicht (2) elektrisch verbunden wird;
(f) Bilden einer zweiten Elektrodenschicht (8), die aus einem transparenten elektrisch leitfähigen Material, wie etwa ITO, gebildet ist, auf der fotoempfindlichen Schicht (1).

2. Verfahren zum Herstellen einer Fotodetektionsvorrichtung nach Anspruch 1, **dadurch gekennzeichnet, dass** Schritt (c) eine Molekularadhäsion umfasst.

3. Verfahren zum Herstellen einer Fotodetektionsvorrichtung nach Anspruch 2, **dadurch gekennzeichnet, dass** Schritt (c) nach der Molekularadhäsion eine Wärmebehandlung umfasst, wobei wenigstens eines der Materialien, die die Feldisolationsschicht (3) darstellen, zum Verbessern der Bondung, wenn diese Wärmebehandlung vorgenommen wird, ausgewählt wird.

4. Verfahren zum Herstellen einer Fotodetektionsvorrichtung nach einem der Ansprüche 1 bis 3, **dadurch gekennzeichnet, dass** das Material, das für die Feldisolationsschicht (3) ausgewählt wird, ein Dielektrikum ist, wie etwa SiO₂, Si₃N₄ oder SiₓO_{y}N_{z}.

5. Verfahren zum Herstellen einer Fotodetektionsvorrichtung nach einem der Ansprüche 1 bis 4, **dadurch gekennzeichnet, dass** der Schritt des Entfernens des ersten Substrats (5) durch wenigstens eine der folgenden Techniken realisiert wird: chemisches Ätzen, selektives chemisches Ätzen, Schleifen, Polieren, CMP.

6. Verfahren zum Herstellen einer Fotodetektionsvorrichtung nach einem der Ansprüche 1 bis 5, **dadurch gekennzeichnet, dass** es einen Schritt des Bildens einer Versprödungszone (4) in dem ersten Substrat (5) durch Implantation von Atomspezies, wie etwa von Wasserstoff und/oder Helium, umfasst, und dass der Schritt des Entfernens des ersten Substrats (5) eine Energieeingabe zum Ablösen des Substrats (5) über der Versprödungszone (4) umfasst.

7. Verfahren zum Herstellen einer Fotodetektionsvorrichtung nach einem der Ansprüche 1 bis 5, **dadurch gekennzeichnet, dass** es ferner Bilden einer Versprödungszone (4) in dem ersten Substrat (5) durch die folgenden Schritte umfasst:
- Bereitstellen eines dritten und eines vierten Wafers;
- Ätzen einer Oberfläche des dritten und/oder vierten Wafers, um die Oberflächenrauigkeit zu erhöhen;
- Bonden des dritten und vierten Wafers an der (den) rauen Oberfläche(n), wodurch das erste Substrat (5) gebildet wird, wobei die raue Grenzfläche die Versprödungszone (4) ist,
und dass der Schritt des Entfernens des ersten Substrats (5) eine Energieeingabe zum Ablösen des Substrats (5) über der Versprödungszone (4) umfasst.

8. Verfahren zum Herstellen einer Fotodetektionsvorrichtung nach einem der Ansprüche 6 bis 7, **dadurch gekennzeichnet, dass** Schritt (d) ferner Entfernen des verbleibenden Teils (5') des ersten Substrats (5) unter Einsatz von wenigstens einer der folgenden Techniken umfasst: selektives chemisches Ätzen, Polieren, CMP, Oxidation, thermisches Tempern.

9. Verfahren zum Herstellen einer Fotodetektionsvorrichtung nach einem der Ansprüche 1 bis 8, **dadurch gekennzeichnet, dass** das Bilden der fotoempfindlichen Schicht (1) auf dem ersten Substrat (5) ein Kristallwachstum und eine Dotierung umfasst.

10. Verfahren zum Herstellen einer Fotodetektionsvorrichtung nach einem der Ansprüche 1 bis 9, **dadurch gekennzeichnet, dass** die Via-Löcher während des Schrittes (e) durch die Oberfläche der Schaltkreisschicht (2) von Eingängen mancher elektronischer Komponenten der Schaltkreisschicht (2) zu der fotoempfindlichen Schicht (1) gebildet werden.

11. Verfahren zum Herstellen einer Fotodetektionsvorrichtung nach einem der Ansprüche 1 bis 10, **dadurch gekennzeichnet, dass** die Bildung der Feldisolationsschicht (3) gemäß Schritt (b) die Bildung einer Abschirmung für Photonen in der Peripherie der Feldisolationsschicht (3) über eine festgelegten Breite umfasst.

12. Verfahren zum Herstellen einer Fotodetektionsvorrichtung nach einem der Ansprüche 1 bis 11, **dadurch gekennzeichnet, dass** die Schaltkreisschicht (2) mehrere Transistoren (20) umfasst, und dass die Schaltkreisschicht (2) so strukturiert ist, dass, sobald Schritt (e) implementiert ist, Teile der fotoempfindlichen Schicht (1) elektrisch mit manchen Transistoren durch manche leitfähige Vias verbunden sind, wodurch dementsprechend mehrere Fotodetektionseinheiten (100) oder Pixel gebildet werden.

13. Verfahren zum Herstellen einer Fotodetektionsvorrichtung nach Anspruch 12, **dadurch gekennzeichnet, dass** die elektronischen Komponenten (20) in den Fotodetektionseinheiten (100) CMOS-Komponenten umfassen.

## Revendications

1. Procédé de fabrication d'un dispositif de photodétection comprenant les étapes consitant à :
(a) fournir une première plaquette (I), comprenant les étapes suivantes :
- former une couche photosensible (1) constituée d'un matériau choisi parmi les matériaux semi-conducteurs cristallins, sur un premier substrat (5);
- former une première couche d'électrode (7) en un matériau électriquement conducteur sur la couche photosensible (1);
(b) fournir une seconde plaquette (II), comprenant les étapes suivantes :
- former une couche de circuit (2) comprenant des composants électroniques sur un substrat de support (9),
- former une couche d'isolation de champ (3) recouvrant la couche de circuit (2);
(c) lier la première plaquette (I) et la seconde plaquette (II) de manière à former une structure comprenant successivement le substrat de support (9), la couche de circuit (2), la couche d'isolation de champ (3), la première couche d'électrode (7), la couche photosensible (1) et le premier substrat (5);
(d) enlever le premier substrat (5);
(e) former un passage conducteur électriquement (40) de manière à connecter électriquement la couche photosensible (1) aux entrées de certains composants électroniques de la couche de circuit (2).
(f) former une seconde couche d'électrode (8) constituée d'un matériau conducteur électrique transparent, tel que l'ITO, sur la couche photosensible (1).

2. Procédé de fabrication d'un dispositif de photodétection selon la revendication 1, **caractérisé en ce que** l'étape (c) comprend une adhésion moléculaire.

3. Procédé de fabrication d'un dispositif de photodétection selon la revendication 2, **caractérisé en ce que** l'étape (c) comprend, après l'adhésion moléculaire, un traitement thermique, au moins l'un des matériaux qui constituent la couche d'isolation de champ (3) étant choisi pour améliorer la liaison lors du traitement thermique.

4. Procédé de fabrication d'un dispositif de photodétection selon l'une des revendications 1 à 3, **caractérisé en ce que** le matériau choisi pour la couche d'isolation de champ (3) est un diélectrique, tel que SiO₂, Si₃N₄ ou SiₓO_{y}N_{z}.

5. Procédé de fabrication d'un dispositif de photodétection selon l'une des revendications 1 à 4, **caractérisé en ce que** l'étape d'enlèvement du premier substrat (5) est réalisée par au moins l'une des techniques suivantes : gravure chimique, gravure chimique sélective, meulage, polissage, polissage chimico-mécanique CMP.

6. Procédé de fabrication d'un dispositif de photodétection selon l'une des revendications 1 à 5, **caractérisé en ce qu'**il comprend une étape de formation d'une zone de fragilisation (4) dans le premier substrat (5) par implantation d'espèces atomiques, telles que l'hydrogène et/ou l'hélium et **en ce que** l'étape de retrait du premier substrat (5) comprend un apport d'énergie pour détacher ledit substrat (5) sur ladite zone de fragilisation (4).

7. Procédé de fabrication d'un dispositif de photodétection selon l'une des revendications 1 à 5, **caractérisé en ce qu'**il comprend en outre la formation d'une zone de fragilisation (4) dans le premier substrat (5) par les étapes consistant à :
- fournir une troisième et une quatrième plaquettes;
- graver une surface d'au moins l'une des troisième et quatrième plaquettes, afin d'augmenter la rugosité de surface;
- coller les troisième et quatrième plaquettes sur la ou les surfaces rugueuses, formant ainsi ledit premier substrat (5), l'interface rugueuse étant ladite zone de fragilisation (4),
et **en ce que** l'étape d'enlèvement du premier substrat (5) comprend un apport d'énergie pour détacher ledit substrat (5) sur ladite zone de fragilisation (4).

8. Procédé de fabrication d'un dispositif de photodétection selon l'une des revendications 6 à 7, **caractérisé en ce que** l'étape (d) comprend en outre l'enlèvement de la partie restante (5') du premier substrat (5), en utilisant au moins l'une des techniques suivantes : gravure chimique sélective, polissage, polissage chimico-mécanique CMP, oxydation, recuit thermique.

9. Procédé de fabrication d'un dispositif de photodétection selon l'une des revendications 1 à 8, **caractérisé en ce que** la formation de la couche photosensible (1) sur le premier substrat (5) comprend la croissance et le dopage de cristaux.

10. Procédé de fabrication d'un dispositif de photodétection selon l'une des revendications 1 à 9, **caractérisé en ce que** les trous de passage sont formés pendant l'étape (e) à travers la surface de la couche de circuit (2), à partir des entrées de certains composants électroniques de la couche de circuit (2) jusqu'à la couche photosensible (1).

11. Procédé de fabrication d'un dispositif de photodétection selon l'une des revendications 1 à 10, **caractérisé en ce que** la formation de la couche d'isolation de champ (3) selon l'étape (b) comprend la formation d'un blindage aux photons dans la périphérie de la couche d'isolation de champ (3) sur une largeur déterminée.

12. Procédé de fabrication d'un dispositif de photodétection selon l'une des revendications 1 à 11, **caractérisé en ce que** la couche de circuit (2) comprend une pluralité de transistors (20), et **en ce que** la couche de circuit (2) est structurée de telle sorte qu'une fois l'étape (e) réalisée, des parties de la couche photosensible (1) sont reliées électriquement à certains transistors par des passages conducteurs, formant ainsi une pluralité d'unités de photodétection (100) ou de pixels.

13. Procédé de fabrication d'un dispositif de photodétection selon la revendication 12, **caractérisé en ce que** les composants électroniques (20) dans les unités de photodétection (100) comprennent des composants CMOS.
